(19) Europäisches Patentamt
European Patent Office
Office européen des brevets

(11) **EP 1 395 843 B1**

(12) **FASCICULE DE BREVET EUROPEEN**

(45) Date de publication et mention
de la délivrance du brevet:
**29.08.2007 Bulletin 2007/35**

(21) Numéro de dépôt: **02748949.1**

(22) Date de dépôt: **12.06.2002**

(51) Int Cl.:
**G01R 33/00** *(2006.01)*

(86) Numéro de dépôt international:
**PCT/FR2002/002007**

(87) Numéro de publication internationale:
**WO 2002/101405 (19.12.2002 Gazette 2002/51)**

(54) **PROCEDE DE DETERMINATION DE L'AIMANTATION ET DU CHAMP RAYONNE PAR UNE TOLE FERROMAGNETIQUE**

VERFAHREN ZUR BESTIMMUNG DER MAGNETISIERUNG UND DES ABGESTRAHLTEN FELDS EINES BLECHS

METHOD FOR DETERMINING MAGNETISATION AND THE FIELD RADIATED BY A FERROMAGNETIC PLATE

(84) Etats contractants désignés:
**DE GB IT NL**

(30) Priorité: **12.06.2001 FR 0108292**

(43) Date de publication de la demande:
**10.03.2004 Bulletin 2004/11**

(73) Titulaires:
• **Etat Français représenté par le Délégué Général pour L'Armement**
**94114 Arcueil Cedex (FR)**
• **INSTITUT NATIONAL POLYTECHNIQUE DE GRENOBLE**
**38031 Grenoble Cedex 1 (FR)**

(72) Inventeurs:
• **CHADEBEC, Olivier**
**F-38100 Grenoble (FR)**
• **COULOMB, Jean-Louis**
**F-38330 Saint Ismier (FR)**

(56) Documents cités:
FR-A- 2 659 787 FR-A- 2 678 236
US-A- 5 189 590

• KILDISHEV A V ET AL: "Multipole imaging of an elongated magnetic source" INTERMAG 2000 DIGEST OF TECHNICAL PAPERS. 2000 IEEE INTERNATIONAL MAGNETICS CONFERENCE, TORONTO, ONT., CANADA, 9-13 APRIL 2000, vol. 36, no. 5, pt.1, pages 3108-3111, XP002191099 IEEE Transactions on Magnetics, Sept. 2000, IEEE, USA ISSN: 0018-9464
• SCHMIDT A: "DER MAGNETISCHE SCHIFFSSCHUTZ" SOLDAT UND TECHNIK, UMSCHAU VERLAG. FRANKFURT AM MAIN, DE, vol. 39, no. 6, 1 juin 1996 (1996-06-01), pages 392-394,396-397, XP000589899 ISSN: 0038-0989

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

L'invention concerne le domaine des dispositions et appareils pour la mesure de l'intensité et de la direction du champ magnétique émis par une plaque ou une structure, telle par exemple la coque d'un navire ainsi que le domaine des aménagements pour là démagnétisation des navires.

Il est connu que la présence de matériaux magnétiques à bord d'un navire le rend détectable et identifiable par des moyens de détection de sa signature magnétique communément appelés détecteurs d'anomalie magnétique. Ces moyens de détection peuvent par exemple être embarqués à bord d'un bâtiment, d'une mine, d'une torpille, d'un missile ou d'un avion.

Pour limiter la signature magnétique d'un navire, il est connu d'utiliser des matériaux amagnétiques. Toutefois, il subsiste toujours, à bord, des matériaux ferromagnétiques. Pour limiter le coût des navires, il paraît préférable de réaliser une coque métallique ferromagnétique et de générer, à l'aide de capteurs de champ (magnétomètres) installés à l'intérieur du navire et de boucles d'immunisation, des champs magnétiques aptes à compenser ceux liés à la coque elle-même.

Toutefois, pour réaliser cette compensation, il est nécessaire de déterminer au préalable l'aimantation de la coque. La connaissance de cette aimantation permet ensuite de déterminer les courants, dans chacune des boucles d'immunisation, nécessaires à cette compensation.

Un des objectifs de l'invention est de fournir un procédé permettant d'estimer, à l'aide de capteurs de champ (magnétomètres) l'aimantation d'une tôle (plaque d'acier ferromagnétique de faible épaisseur) et d'en déduire le champ rayonné par la tôle partout en dehors de celle-ci.

L'aimantation d'un matériau ferromagnétique est la résultante de la somme d'une aimantation induite, qui correspond à l'aimantation prise par le matériau sous l'influence d'un champ inducteur, tel le champ terrestre par exemple, et d'une aimantation permanente qui dépend de l'historique du matériau. L'aimantation induite est parfaitement déterministe et ne dépend que du champ inducteur, de la géométrie de la tôle (la coque) et de la perméabilité relative du matériau, par contre, l'aimantation permanente évolue lentement au cours du temps en fonction du champ inducteur, des contraintes thermiques, des contraintes de pression ou encore des conditions de fabrication. Ces paramètres sont très nombreux et difficilement contrôlables. On ne peut donc pas modéliser l'aimantation permanente, seule la mesure du champ qu'elle induit peut permettre de l'estimer. Du fait de cette dernière et afin de déterminer l'aimantation totale d'une tôle, il est nécessaire de bâtir un modèle reliant la mesure à l'aimantation puis d'inverser celui-ci pour en déduire l'aimantation. On rencontre, par conséquent, toutes les difficultés liées à la résolution des problèmes inverses.

Pour contourner ce problème, on peut citer les brevets FR 2 673 236, FR 2 659 787, US 5 189 590 and FR2679514. Le dernier décrit une station portable de mesure et de réglage de la signature magnétique d'un bâtiment naval permettant de déterminer et de modifier les caractéristiques des courants circulant dans les boucles d'immunisation magnétique dont est pourvu ce bâtiment.

Cette station comprend plusieurs capteurs magnétiques formant un chapelet déformable et aptes à être déposés sur le fond de la mer et reliés au bâtiment par des moyens de transmission/réception des signaux qu'ils génèrent.

Le procédé de détermination de la signature magnétique du bâtiment consiste à :

- évaluer la forme du chapelet de capteurs de façon à déterminer leur position relative,
- déterminer la position du bâtiment par rapport audit chapelet de capteurs,
- déterminer une trajectoire et rassembler les données provenant des capteurs durant au moins un passage du bâtiment selon ladite trajectoire.

Cette méthode permet d'estimer, avec un chapelet de capteurs placés nécessairement à l'extérieur du bâtiment, l'aimantation visible en champ lointain, mais elle ne permet pas d'estimer l'aimantation d'une anomalie à l'aide de capteurs placés à l'intérieur de cette dernière.

Actuellement, une des méthodes connues pour déterminer la signature d'un navire à coque métallique à partir de mesures à l'intérieur consiste à déterminer par inversion d'un système linéaire, non pas l'aimantation, mais la distribution d'une grandeur mathématique appelée charge magnétique aux noeuds de la surface maillée de la coque puis d'en déduire le champ à la distance de référence définie. Cette méthode cherche à estimer une charge à chaque noeud du maillage surfacique en la considérant comme étant un élément indépendant décorrélé de ses voisins. Cette solution nécessite de mettre en oeuvre un nombre important de capteurs compte tenu qu'il y a autant de paramètres à estimer que de noeuds définissant le maillage. De plus, la distribution de charges obtenue n'est pas nécessairement physique et le résultat en terme de signature risque d'être instable.

Le but de l'invention est de résoudre les inconvénients susmentionnés en proposant un procédé permettant d'effectuer une estimation physique de l'aimantation totale induite et permanente d'une tôle. Cette aimantation peut alors être exploitée pour estimer le champ en tous points et permet d'estimer la signature de référence d'un navire à coque métallique. De plus, les capteurs peuvent être placés à l'intérieur ou à l'extérieur de l'anomalie magnétique, c'est-à-dire de la plaque ou de la coque.

Par ailleurs, l'aimantation estimée peut être exploitée par un dispositif de compensation directe des aimantations, basé sur le calcul de courants des boucles d'immunisation minimisant, non pas le champ estimé sur des points de référence, mais directement l'aimantation de la coque. Une telle méthode de compensation a l'avantage de minimiser le champ partout et, par conséquent, aussi bien au-dessus vis-à-vis des risques aériens qu'en dessous de la coque vis-à-vis des risques liés aux mines et aux torpilles. Cela permet d'éviter les doubles jeux de réglages habituellement rencontrés sur les procédures opérationnelles des navires, selon que le risque de détection est aéroporté (détection par avion ) ou lié aux mines.

L'invention consiste en un procédé de détermination de l'aimantation et du champ rayonné par une tôle ferromagnétique utilisant des capteurs de champ magnétique répartis le long de cette tôle et à des positions connues par rapport à cette dernière, caractérisé en ce qu'il consiste à :

- réaliser un maillage de cette tôle par découpage en surfaces élémentaires
- réaliser une première modélisation du champ magnétique associé aux mesures et fonction du maillage surfacique réalisé de la tôle, de son épaisseur, des mesures, des coordonnées des points de mesure et du champ inducteur $B_0=\mu_0 H_0$,
- réaliser une deuxième modélisation du comportement physique du matériau constituant la tôle à partir du maillage, de son épaisseur, du champ inducteur, de la perméabilité réversible du matériau,
- à calculer les aimantations permanentes et induites de chacune des surfaces élémentaires à partir desdites première et deuxième modélisations et des mesures effectuées par lesdits capteurs de champ magnétique,
- à calculer la signature magnétique de la tôle en tout point à partir, desdites aimantations permanentes et induites de chacune des surfaces élémentaires, du maillage surfacique réalisé de la tôle, de son épaisseur, des mesures, des coordonnées des points de calcul et du champ inducteur $B_0 = \mu_0 H_0$

Par tôle, il faut entendre soit une seule tôle soit un ensemble de tôles délimitant ainsi un volume.

Selon une caractéristique particulière, caractérisé en ce que la première modélisation consiste à modéliser le champ magnétique par l'une des deux formules suivantes :

$$\mathbf{B} = \mathbf{B_0} + \frac{e\mu_0}{4\pi} \sum_{N_l} \int_{L_i} \mathbf{M}_i . \mathbf{n}_i \frac{\vec{r}}{r^3} dL_i$$

$$\mathbf{B} = \mathbf{B_0} - \frac{e\mu_0}{4\pi} \sum_{N_l} \mathbf{grad} \iint_{S_i} \mathbf{M}_i . \frac{\vec{r}}{r^3} dS_i$$

**où,**

$\mathbf{M_i}$ est l'aimantation totale soit la somme de l'aimantation permanente $\mathbf{M}_i^{\mathbf{per}}$ et de l'aimantation induite $\mathbf{M}_i^{\mathbf{ind}}$ de l'élément i,

$\mathbf{N_l}$ est le nombre de surfaces élémentaires,

$\mathbf{L_i}$ les arêtes des surfaces élémentaires,

$\mathbf{S_i}$ les surfaces élémentaires,

$\mathbf{r}$ est la distance entre le point courant de l'arête i et le point de mesure,

$\mathbf{n_i}$ est la normale à l'arête i de l'élément de surface courant, tangentielle à l'élément,

$\mathbf{e}$ est l'épaisseur de la coque,

soit un système matriciel prenant la forme matricielle suivante :

$$B - Bo = FM = FM^{ind} + FM^{per}$$

Selon une autre caractéristique particulière garantissant une grande robustesse vis à vis des erreurs et des bruits de mesures ce qui permet d'envisager son exploitation dans un environnement réel, la deuxième modélisation consiste à modéliser le champ magnétique au niveau de chacun des éléments surfaciques par l'une des deux formules suivantes :

$$\frac{M_i^{ind}}{(\mu_r - 1)} = H_0 - \frac{e}{4\pi} \sum_{N_l} \int_{L_j} M_j^{ind} . n_j \frac{\bar{r}_{ij}}{r_{ij}^3} dL_j - \frac{e}{4\pi} \sum_{N_l} \int_{L_j} M_j^{per} . n_j \frac{\bar{r}_{ij}}{r_{ij}^3} dL_j$$

$$\frac{M_i^{ind}}{(\mu_r - 1)} = H_0 + \frac{e}{4\pi} \sum_{N_l} \mathbf{grad} \iint_{S_j} M_j^{ind} \frac{\vec{r}_{ij}}{r_{ij}^3} dS_j + \frac{e}{4\pi} \sum_{N_l} \mathbf{grad} \iint_{S_j} M_j^{per} \frac{\vec{r}_{ij}}{r_{ij}^3} dS_j$$

où,

$M_j^{ind}$ est l'aimantation induite de la surface élémentaire j,

$M_j^{per}$ est l'aimantation permanente de la surface élémentaire j,

$N_l$ est le nombre de surfaces élémentaires.

$L_j$ les arêtes des surfaces élémentaires,

$S_j$ les surfaces élémentaires,

$r_{ij}$ est la distance entre les barycentres des éléments de surface i et j.

$n_j$ est la normale à l'arête i de l'élément de surface courant, tangentielle à l'élément.

$e$ est l'épaisseur de la coque.

Soit globalement un système matriciel prenant la forme matricielle suivante :

$$(C + Id)M^{ind} + CM^{per} = f(H_0)$$

Selon une caractéristique particulière, le calcul des aimantations permanentes et induites de chacune des surfaces élémentaires est effectué par résolution du système matriciel suivant, sa solution étant $\tilde{M}$ :

$$\begin{bmatrix} F & F \\ C + Id & C \end{bmatrix} \begin{bmatrix} M^{ind} \\ M^{per} \end{bmatrix} = \begin{bmatrix} B - Bo \\ D \end{bmatrix}$$

Selon une caractéristique additionnelle, le calcul de la signature magnétique S de la tôle en un point I est effectué par l'une des formules suivantes :

$$S = \mathbf{B_0} + \frac{e\mu_0}{4\pi} \sum_{N_l} \int_{L_i} \tilde{\mathbf{M}}_i . \mathbf{n}_i \frac{\vec{r}}{r^3} dL_i$$

$$S = \mathbf{B_0} - \frac{e\mu_0}{4\pi} \sum_{N_l} \mathbf{grad} \iint_{S_i} \tilde{\mathbf{M}}_i . \frac{\vec{r}}{r^3} dS_i$$

$\tilde{M}$ représente les aimantations estimées

$N_l$ est le nombre d'éléments de surface (facette triangulaire ou quadrangulaire).

$L_i$ les arêtes des éléments,

$S_i$ les surface des éléments

$r$ est la distance entre le barycentre de l'élément de surface courant et le point de calcul du champ.

$n_i$ est la normale à l'arête i de l'élément de surface courant, tangentielle à l'élément.

$e$ est l'épaisseur de la coque.

Selon une autre caractéristique, un procédé selon l'invention comporte une étape consistant à compenser l'aimantation de la tôle ou sa signature magnétique par utilisation d'un système de boucles d'immunisation disposées à proximité de la tôle et dans lesquelles peut être généré un courant d'intensité I réglable, cette étape pouvant consister à établir un système linéaire G reliant les courants I aux aimantations M' qu'ils génèrent sur la tôle et fonction des géométries de la tôle et des boucles, et ensuite à minimiser la fonction $\tilde{M}$ -M', cette minimisation de la fonction $\tilde{M}$ -M' pouvant être est effectuée par la méthode des moindres carrés.

Un procédé selon l'invention peut notamment être appliqué à la détermination de la signature magnétique de la coque d'un navire et même à la détermination de l'aimantation et de la signature magnétique de l'ensemble d'un navire.

Il peut être appliqué à la détermination de l'aimantation et de la signature magnétique d'une structure ferromagnétique.

D'autres caractéristiques et avantages de l'invention apparaîtront à la lecture de la description suivante d'un mode de réalisation préférentiel de l'invention, donné à titre de simple exemple illustratif et non limitatif, et des dessins annexés, dans lesquels :

- la figure 1 présente les moyens de mise en oeuvre d'un procédé selon l'invention,
- la figure 2 montre un diagramme des différentes étapes d'un procédé selon le mode de réalisation préférentiel,
- la figure 3 présente la modélisation d'une coque et son maillage surfacique,
- la figure 4 présente le spectre des valeurs singulières,
- la figure 5 présente l'aimantation de chaque surface élémentaire du maillage surfacique,
- la figure 6 présente la signature magnétique prédite de la coque,
- les figures 7, 8 et 9 représentent dans un repère orthonormé Ox,y,z la composante respectivement suivant l'axe x, l'axe y et l'axe z de la signature magnétique de la coque prédite et mesurée.

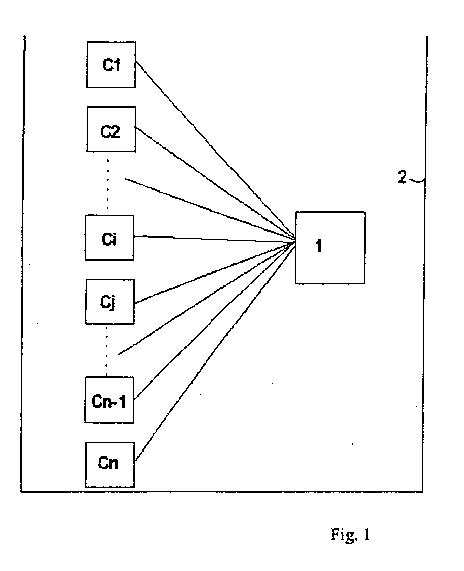

La figure 1 présente les moyens de mise en oeuvre d'un procédé selon le mode de réalisation de l'invention. Ces moyens comportent n capteurs magnétiques **C1 à Cn**, par exemple des magnétométres, chacun étant apte à transmettre un signal à des moyens de traitement 1 de ces signaux, en l'occurrence un micro-ordinateur.

Cet ordinateur et lesdits capteurs sont disposés à l'intérieur de la coque 2 d'un navire.

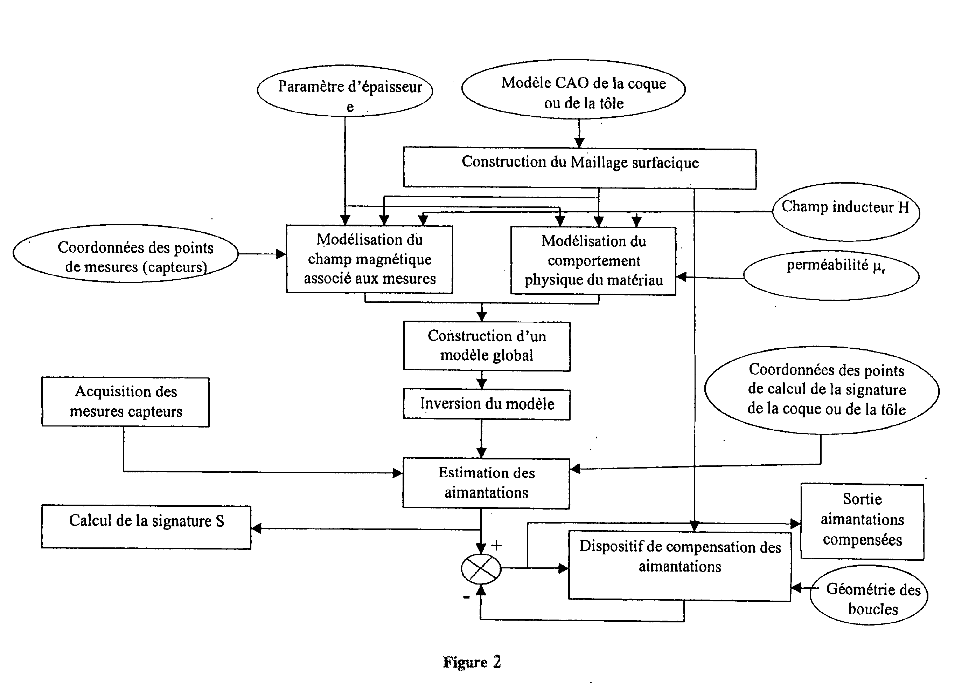

Le procédé selon le mode préférentiel de réalisation décrit consiste dans un premier temps à réaliser un modèle, par exemple par conception assistée par ordinateur, de la coque 2 du navire en respectant les proportions des différentes surfaces puis un maillage surfacique est réalisé sur toute la surface de la coque, chaque surface élémentaire pouvant par exemple être constituée par un triangle ou par un carré comme montré sur la figure 2, la position de chacune des surfaces élémentaires étant définie par rapport à un repère triaxe prédéterminé.

L'étape suivante consisté à établir un modèle associé aux mesures réalisées par les n capteurs C1 à Cn.

Le modèle, noté F, associé aux mesures notées B utilise la connaissance du modèle géométrique constitué du maillage surfacique de la coque, de son épaisseur, des mesures, les coordonnées des points de mesure et le champ inducteur $B_0 = \mu_0 H_0$ ($\mu_0$ est la perméabilité du vide ou de l'air):

$$\mathbf{B} = \mathbf{B_0} + \frac{e\mu_0}{4\pi} \sum_{N_l} \int_{L_i} \mathbf{M}_i . \mathbf{n}_i \frac{\vec{r}}{r^3} dL_i$$

$$\mathbf{B} = \mathbf{B_0} - \frac{e\mu_0}{4\pi} \sum_{N_l} \mathbf{grad} \iint_{S_i} \mathbf{M}_i \cdot \frac{\vec{r}}{r^3} dS_i$$

où,

$\mathbf{M_i}$ est aimantation totale soit la somme de l'aimantation permanente $\mathbf{M_i^{per}}$ et de l'aimantation induite $\mathbf{M_i^{ind}}$ de l'élément i,

$\mathbf{N_l}$ est le nombre de surfaces élémentaires,

$\mathbf{L_i}$ les arêtes des surfaces élémentaires,

$\mathbf{S_i}$ les surfaces élémentaires,

$\mathbf{r}$ est la distance entre le point courant de l'arête i et le point de mesure,

$\mathbf{n_i}$ est la normale à l'arête i de l'élément de surface courant, tangentielle à l'élément,

$\mathbf{e}$ est l'épaisseur de la coque,

Cette équation ramène numériquement à résoudre un problème qui prend la forme matricielle suivante :

$$\mathrm{B} - \mathrm{Bo} = \mathrm{FM} = \mathrm{FM}^{ind} + \mathrm{FM}^{per}$$

Ce système possède les caractéristiques suivantes :

- Il est représentatif des mesures réalisées par les capteurs.
- Il est a priori sous-dimensionné c'est-à-dire qu'il y a moins d'équations que d'inconnues.
- Il est mal conditionné c'est-à-dire qu'il est difficile à inverser, cette difficulté augmentant avec le nombre de capteurs.

Pour combler cet inconvénient un modèle du comportement physique de l'aimantation est réalisé.

La formulation globale du comportement physique exploite la connaissance du modèle géométrique constitué du maillage surfacique de la coque et de son épaisseur, du champ inducteur noté $H_0$ et de la perméabilité relative du matériau noté $\mu$r. Cette formulation s'écrit à partir de l'équation très générale suivante:

$$\mathbf{B} = \mu_0 (\mathbf{H} + \mathbf{M}) \qquad (1)$$

à laquelle il est rajouté l'équation intrinsèque au matériau suivante :

$$\mathbf{B} = \mu\mathbf{H} + \mathbf{B_p} \qquad (2)$$

En combinant (1) et (2), on obtient:

$$\mathbf{H} = \mu_r \mathbf{H} + \mathbf{M} - \mathbf{M_p} \qquad (3)$$

Avec $\mathbf{M_p}$ l'aimantation permanente, $\mathbf{M_i}$ l'aimantation induite et $\mathbf{M}$ l'aimantation totale. Comme $\mathbf{M}\text{-}\mathbf{M_r}\text{=}\mathbf{M_i}$, on obtient

$$\mathbf{M_i} = (\mu_r - 1)\mathbf{H}$$

$\mathbf{M_i}$ est créée à la fois par $\mathbf{M_r}$ et $\mathbf{M_i}$. de toute la tôle. On a alors:

$$\frac{\mathbf{M}_i^{ind}}{(\mu_r - 1)} = \mathbf{H}_0 - \frac{e}{4\pi}\sum_{N_l}\int_{L_j}\mathbf{M}_j^{ind}.\mathbf{n}_j\,\frac{\vec{r}_{ij}}{r_{ij}^3}dL_j - \frac{e}{4\pi}\sum_{N_l}\int_{L_j}\mathbf{M}_j^{per}.\mathbf{n}_j\,\frac{\vec{r}_{ij}}{r_{ij}^3}dL_j \quad (4)$$

soit

$$\frac{\mathbf{M}_i^{ind}}{(\mu_r - 1)} = \mathbf{H}_0 + \frac{e}{4\pi}\sum_{N_l}\mathbf{grad}\iint_{S_j}\mathbf{M}_j^{ind}\,\frac{\vec{r}_{ij}}{r_{ij}^3}dS_j + \frac{e}{4\pi}\sum_{N_l}\mathbf{grad}\iint_{S_j}\mathbf{M}_j^{per}\,\frac{\vec{r}_{ij}}{r_{ij}^3}dS_j$$

où,

$\mathbf{M}_j^{ind}$ est l'aimantation induite de la surface élémentaire j,

$\mathbf{M}_j^{per}$ est l'aimantation permanente de la surface élémentaire j,

$N_l$ est le nombre de surfaces élémentaires.

$L_j$ les arêtes des surfaces élémentaires,

$S_j$ les surfaces élémentaires,

$r_{ij}$ est la distance entre les barycentres des éléments de surface i et j.

$n_j$ est la normale à l'arête i de l'élément de surface courant, tangentielle à l'élément.

$e$ est l'épaisseur de la coque.

En écrivant cette équation pour chaque élément, numériquement on obtient le système matriciel suivant:

$$(C + Id)M^{ind} + CM^{per} = f(H_0)$$

où C est une matrice qui dépend du maillage de la géométrie, de l'épaisseur de la tôle et de la perméabilité relative $\mu r$, Id est la matrice identité, Mi et Mp sont respectivement les aimantations induite et permanente telles que M = Mi + Mp.

Ce système possède les caractéristiques suivantes:

- Il est représentatif du comportement physique de la tôle
- Il est sous-dimensionné c'est-à-dire qu'il comporte plus d'équations que d'inconnues,
- Il est bien conditionné c'est-à-dire facile à inverser.

Les 2 modèles doivent être vérifiés en même temps, ce qui conduit, à construire puis à résoudre le modèle global suivant :

$$\begin{bmatrix} F & F \\ C + Id & C \end{bmatrix} \begin{bmatrix} Mi \\ Mp \end{bmatrix} = \begin{bmatrix} B - Bo \\ D \end{bmatrix}$$

Soit :

$$AM = Y$$

avec :

$$A = \begin{bmatrix} F & F \\ C + Id & C \end{bmatrix} \quad M = \begin{bmatrix} Mi \\ Mp \end{bmatrix} \quad Y = \begin{bmatrix} B - Bo \\ D \end{bmatrix}$$

La matrice résultante , notée A, à inverser est alors naturellement bien conditionnée, donc facile à inverser, malgré que le système soit sous dimensionné, elle ne nécessite ni d'estimation empirique de coefficients de pondération ni d'utiliser une technique de régularisation particulière ; une inversion généralisée par décomposition en valeurs singulières est suffisante pour retrouver les aimantations.
L'inversion permet d'obtenir l'estimation de M notée $\tilde{M}$.
La matrice $A_{(X,N)}$ avec N > X peut se décomposer de la manière suivante :

$$A_{(X,N)} = P_{(X,N)} L_{(N,N)} Q^{T}{}_{(N,N)}$$

où les matrices P et Q sont orthogonales, c'est à dire que :

$$\sum_{i=1}^{X} P_{ik} P_{in} = \partial_{kn}$$

$$\sum_{j=1}^{X} Q_{jk} Q_{jn} = \partial_{kn}$$

pour

$$1 \leq k, n \leq N$$

L est une matrice diagonale dont les éléments diagonaux sont les valeurs propres de A. L a la forme suivante :

$$L = \begin{bmatrix} l_1 & 0 & 0 & 0 & 0 \\ 0 & . & 0 & 0 & 0 \\ 0 & 0 & l_i & 0 & 0 & 0 \\ 0 & 0 & 0 & . & 0 \\ 0 & 0 & 0 & 0 & l_N \end{bmatrix}$$

On a alors

$$A^{-1} = QL^{-1}P^T$$

avec $L^{-1}$, qui vaut :

$$L^{-1} = \begin{bmatrix} 1/l_1 & 0 & 0 & 0 & 0 \\ 0 & . & 0 & 0 & 0 \\ 0 & 0 & 1/l_i & 0 & 0 & 0 \\ 0 & 0 & 0 & . & 0 \\ 0 & 0 & 0 & 0 & 1/l_N \end{bmatrix}$$

Lorsqu'une valeur propre $l_i$ est nulle, elle est remplacée par 0 dans $L^{-1}$. On obtient l'estimation de M, $\tilde{M}$ tout simplement par :

$$\tilde{M} = A^{-1}Y \qquad (5)$$

Le modèle, noté A, associé aux points de calcul de la signature notée S s'écrit théoriquement de la même manière que le modèle associé aux points de mesures décrit au 0. Il utilise la connaissance du modèle géométrique constitué du maillage surfacique de la coque, de son épaisseur, les mesures, les coordonnées des points de calcul et le champ inducteur $B_0 = \mu_0 H_0$ ($\mu_0$ est la perméabilité du vide ou de l'air):

$$S = \mathbf{B_0} + \frac{e\mu_0}{4\pi} \sum_{N_1} \int_{L_i} \tilde{\mathbf{M}}.\mathbf{n}_i \frac{\vec{\mathbf{r}}}{r^3} dL_i \qquad (6)$$

$\tilde{M}$ représente les aimantations estimées
$N_l$ est le nombre d'éléments de surface (facette triangulaire ou quadrangulaire).
$L_i$ les arêtes des éléments.
$r$ est la distance entre le barycentre de l'élément de surface courant et le point de calcul du champ.
$n_i$ est la normale à l'arête i de l'élément de surface courant, tangentielle à l'élément.
$e$ est l'épaisseur de la coque.
Cette équation ramène, numériquement, à résoudre un problème qui prend la forme matricielle suivante :

$$S = A\widetilde{M}$$

donc un simple produit de matrice

Une étape complémentaire consiste à compenser l'aimantation de la tôle ou sa signature magnétique par utilisation d'un système connu de boucles d'immunisation disposées à proximité de la tôle et dans lesquelles peuvent être générés des courants d'intensité I réglable. Pour cela, on établit un système linéaire G, qui est en général largement surdimensionné, reliant les courants I aux aimantations sur une coque compte tenu des géométries de la coque et des boucles d'immunisation. On peut écrire alors simplement que :

$$\widetilde{M} = GI$$

Les courants de compensation I sont alors estimés, par exemple par inversion généralisée par décomposition en valeurs singulières de la matrice G, de la manière suivante :

$$I = (G^T G)^{-1} G^T \widetilde{M}$$

L'étape suivante consiste à minimiser la fonction $\widetilde{M}$ -M', cette minimisation de la fonction $\widetilde{M}$ -M' étant effectuée par la méthode des moindres carrés.

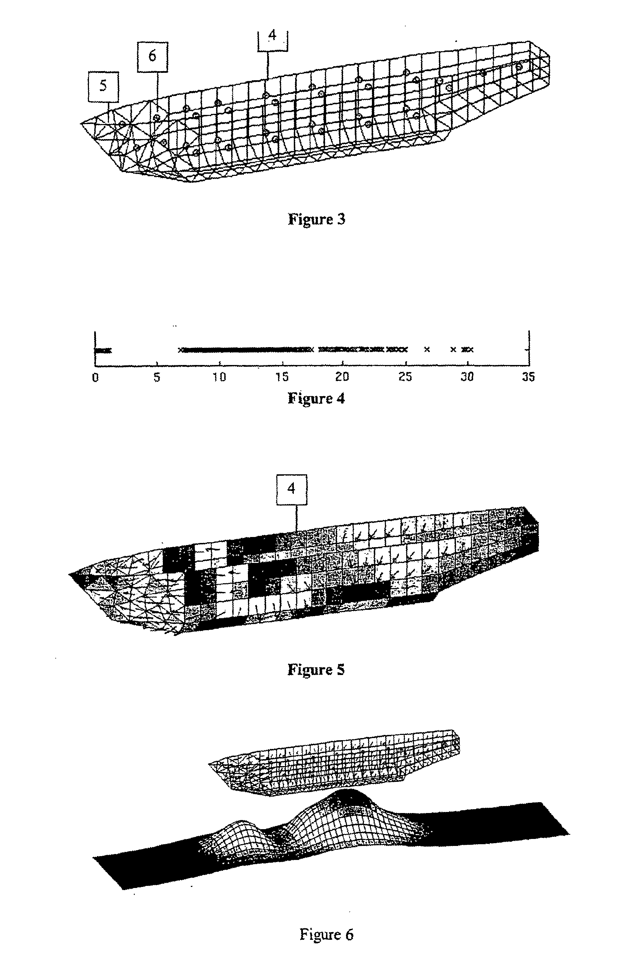

Le procédé selon le mode de réalisation précédemment écrit a été mis en oeuvre sur une coque en acier qui a été modélisée sur un ordinateur et dont un maillage surfacique, comme montré sur la figure 3, a été réalisé. Ce modèle comporte 271 surfaces élémentaires qui ont des formes carrées 4 ou triangulaires 5. Comme montré sur la figure 3, 32 capteurs mini-Crouzet triaxiaux 6 ont été déposés à l'intérieur de la coque.

La coque a été placée suivant un cap nord de façon à ne pas être obligé de simuler le champ terrestre. Elle est donc placée dans un champ inducteur d'une très bonne homogénéité. Les valeurs de ce champ sont:

$$Box = - 553 \text{ nT}$$

$$Boy = - 22549 \text{ nT}$$

$$Boy = - 40662 \text{ nT}$$

Les capteurs internes 6 ont été montés sur une structure indépendante de la coque. Il est ainsi possible de réaliser deux types de mesures: des mesures du champ à l'intérieur de la maquette et des mesures sans coque, après extraction de celle-ci et remise en place de ladite structure. Cette approche permet, par simple soustraction, de mesurer directement la réaction du matériau vis à vis du champ inducteur tout en s'affranchissant des problèmes inhérents aux offsets des capteurs. Elle est dite différentielle.

Comme la coque a été maillée en 271 éléments surfaciques, il y a donc 542 inconnues à identifier, à partir de 99 données, à savoir 96 mesures provenant des 32 capteurs triaxiaux 6 plus les trois composantes du champ inducteur.

Ensuite les trois étapes suivantes ont été effectuées :

- réaliser une première modélisation du champ magnétique associé aux mesures et fonction du maillage surfacique réalisé de la tôle, de son épaisseur, des mesures, des coordonnées des points de mesure et du champ inducteur $B_0 = \mu_0 H_0$,
- réaliser une deuxième modélisation du comportement physique du matériau constituant la tôle à partir du maillage, de son épaisseur, du champ inducteur, de la perméabilité réversible du matériau.

- calculer les aimantations permanentes et induites de chacune des surfaces élémentaires à partir desdites première et deuxième modélisations et des mesures effectuées par lesdits capteurs de champ magnétique,

Cette dernière étape nécessite l'inversion d'une matrice. Avant de l'inverser, il est nécessaire d'étudier sa décomposition en valeur singulière. A ce sujet, plus les valeurs singulières sont petites, plus le système est difficile à inverser. En particulier, si ces valeurs sont très proches de 0, il est alors nécessaire de mettre en oeuvre des méthodes de régularisation. Ces méthodes sont relativement lourdes pour des problèmes 3D.

Cette décomposition en valeurs singulières, montrées sur la figure 4, fait clairement apparaître deux groupes de valeurs. Le premier groupe est constitué de valeurs importantes, il s'agit des valeurs singulières issues du de la première modélisation . Ce système présente, en effet, un conditionnement relativement faible. Le deuxième groupe présente des valeurs beaucoup plus proche de zéro, il est directement l'image du système de mesures qui possède un très mauvais conditionnement. Celui-ci contribue donc à dégrader le conditionnement global mais dans une moindre mesure puisque le nombre d'équations qui lui est relatif est peu important. Les caractéristique globales du système à inverser sont:

Plus petite valeur singulière: 0,0753 Conditionnement: 400

Le système peu donc être inversé par la méthode des les moindres carrés généralisés sans précaution particulière. Après inversion, nous obtenons donc les aimantations rémanentes et induites, la somme étant l'aimantation totale.

L'aimantation de chacune des surfaces élémentaires est présentée sur la figure 5, d'une part en intensité : plus cette dernière est élevée et plus la surface est d'une couleur sombre, et d'autre part en direction représentée par une flèche.

Par application de l'équation 6, on calcule alors la signature magnétique de la tôle en tout point à partir, desdites aimantations permanentes et induites de chacune des surfaces élémentaires, du maillage surfacique réalisé de la tôle, de son épaisseur, des mesures, des coordonnées des points de calcul et du champ inducteur $B_0 = \mu_0 H_0$

Le module de cette signature magnétique, donc de l'anomalie magnétique ainsi calculée est présentée sur la figure 6.

Afin de montrer la concordance entre les valeurs de signature calculées et les valeurs réelles, 7 capteurs du type Ultra ont été placés dans un plan horizontal situé à 30 cm au-dessous de la coque, et perpendiculairement à l'axe de la coque et sont régulièrement répartis sur une distance totale d'environ 1m.

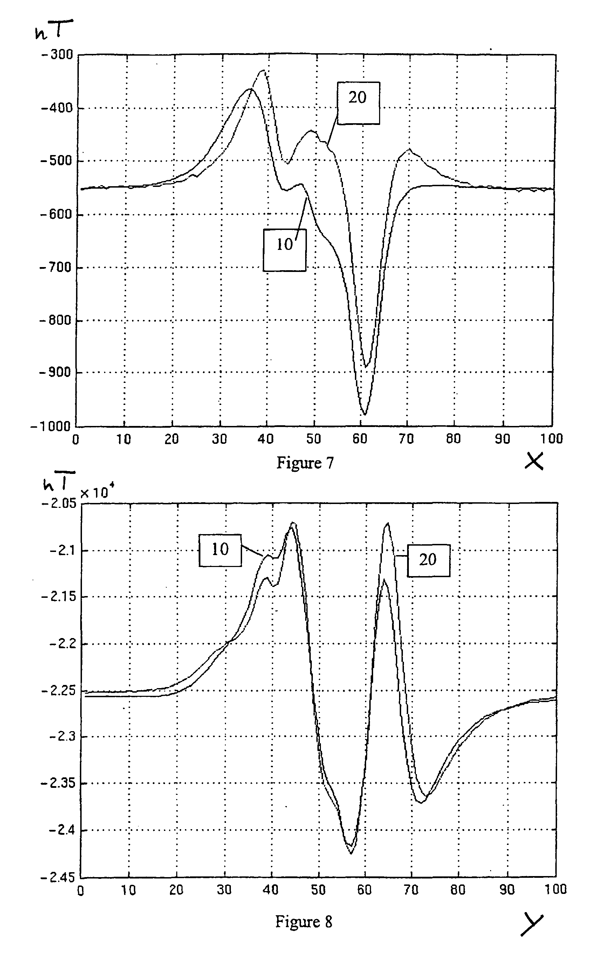

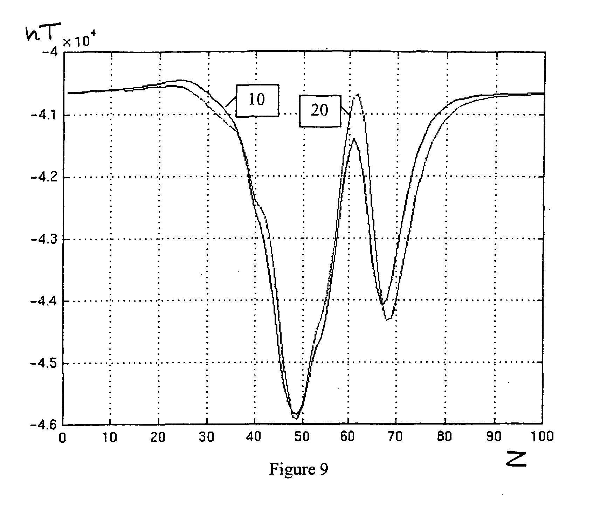

Les résultats sont présentés sur les figures 7, 8 et 9 représentant dans un repère orthonormé Ox,y,z de la composante respectivement suivant l'axe x, l'axe y et l'axe z de la signature magnétique prédite 10 et mesurée 20.

Chaque composante est présentée en ordonnées en nano Tesla tandis que l'abscisse est la distance par rapport au plan de symétrie de la coque.

On constate qu'il y a une très bonne concordance entre les valeurs de signature prédites et mesurées. Ainsi, puisque selon l'invention permet de déterminer avec précision l'aimantation et la signature magnétique de la coque, il est alors possible de compenser, quasiment intégralement l'aimantation de la coque par utilisation d'un système de boucles d'immunisation disposées à proximité de la tôle et dans lesquelles peuvent être généré un courant d'intensité 1 réglable, et par réalisation d'une première étape consistant à établir un système linéaire G reliant les courants I aux aimantations M' qu'ils génèrent sur la coque et fonction des géométries de la tôle et des boucles, et une seconde étape consistant à minimiser la fonction $\tilde{M}$ -M' par la méthode des moindres carrés.

**Revendications**

1. Procédé de détermination de l'aimantation et du champ rayonné par une tôle ferromagnétique utilisant des capteurs de champ magnétique répartis le long de cette tôle et à des positions connues par rapport à cette dernière, **caractérisé en ce qu'**il consiste à :

   - réaliser un maillage de cette tôle par découpage en surfaces élémentaires
   - réaliser une première modélisation du champ magnétique associé aux mesures et fonction du maillage surfacique réalisé de la tôle, de son épaisseur, des mesures, des coordonnées des points de mesure et du champ inducteur $B_0 = \mu_0 H_0$ ,
   - réaliser une deuxième modélisation du comportement physique du matériau constituant la tôle à partir du maillage, de son épaisseur, du champ inducteur, de la perméabilité réversible du matériau,
   - à calculer les aimantations permanentes $M^{per}$ et induites $M^{ind}$ de chacune des surfaces élémentaires à partir desdites première et deuxième modélisations et des mesures effectuées par lesdits capteurs de champ magnétique,
- à calculer la signature magnétique de la tôle en tout point à partir, desdites aimantations permanentes et induites de chacune des surfaces élémentaires, du maillage surfacique réalisé de la tôle, de son épaisseur, des mesures, des coordonnées des points de calcul et du champ inducteur $B_0 = \mu_0 H_0$

2. Procédé selon la revendication 1, **caractérisé en ce que** la première modélisation consiste à modéliser le champ magnétique par une formule reliant le champ magnétique mesuré par les capteurs, l'aimantation, le champ inducteur et la géométrie, telle que l'une des formues suivantes :

$$\mathbf{B} = \mathbf{B_0} + \frac{e\mu_0}{4\pi} \sum_{N_l} \int_{L_i} \mathbf{M}_i.\mathbf{n}_i \frac{\vec{r}}{r^3} dL_i$$

$$\mathbf{B} = \mathbf{B_0} - \frac{e\mu_0}{4\pi} \sum_{N_l} \mathbf{grad} \iint_{S_i} \mathbf{M}_i.\frac{\vec{r}}{r^3} dS_i$$

**où,**

$\mathbf{M_i}$ est aimantation totale soit la somme de l'aimantation permanente $\mathbf{M}_i^{per}$ et de l'aimantation induite $\mathbf{M}_i^{ind}$ de l'élément i,

$\mathbf{N_l}$ est le nombre de surfaces élémentaires,

$\mathbf{L_i}$ les arêtes des surfaces élémentaires,

$\mathbf{S_i}$ les surfaces élémentaires,

$\mathbf{r}$ est la distance entre le point courant de l'arête i et le point de mesure,

$\mathbf{n_i}$ est la normale à l'arête i de l'élément de surface courant, tangentielle à l'élément,

$\mathbf{e}$ est l'épaisseur de la coque,

soit un système matriciel prenant la forme matricielle suivante :

$$B - Bo = FM = FM^{ind} + FM^{per}$$

3. Procédé selon l'une quelconque des revendications 1 et 2, **caractérisé en ce que** la deuxième modélisation consiste à modéliser le comportement magnétique de la tôle par une formule reliant l'aimantation, le champ inducteur, la perméabilité relative réversible du matériau et la géométrie, telle que l'une des formues suivantes :

$$\frac{\mathbf{M}_i^{ind}}{(\mu_r - 1)} = \mathbf{H_0} - \frac{e}{4\pi}\sum_{N_l}\int_{L_j}\mathbf{M}_j^{ind}.\mathbf{n}_j\frac{\vec{r}_{ij}}{r_{ij}^3}dL_j - \frac{e}{4\pi}\sum_{N_l}\int_{L_j}\mathbf{M}_j^{per}.\mathbf{n}_j\frac{\vec{r}_{ij}}{r_{ij}^3}dL_j$$

$$\frac{\mathbf{M}_i^{\text{ind}}}{(\mu_r - 1)} = \mathbf{H}_0 + \frac{e}{4\pi} \sum_{N_i} \mathbf{grad} \iint_{S_j} \mathbf{M}_j^{\text{ind}} \frac{\vec{r}_{ij}}{r_{ij}^3} dS_j + \frac{e}{4\pi} \sum_{N_i} \mathbf{grad} \iint_{S_j} \mathbf{M}_j^{\text{per}} \frac{\vec{r}_{ij}}{r_{ij}^3} dS_j$$

où,

$\mathbf{M}_j^{\text{ind}}$ est l'aimantation induite de la surface élémentaire j,

$\mathbf{M}_j^{\text{per}}$ est l'aimantation permanente de la surface élémentaire j,

$\mathbf{N_l}$ est le nombre de surfaces élémentaires.

$\mathbf{L_j}$ les arêtes des surfaces élémentaires,

$\mathbf{S_j}$ les surfaces élémentaires,

$\mathbf{r_{ij}}$ est la distance entre les barycentres des éléments de surface i et j.

$\mathbf{n_j}$ est la normale à l'arête i de l'élément de surface courant, tangentielle à l'élément.

$\mathbf{e}$ est l'épaisseur de la coque.

Soit globalement un système matriciel prenant la forme matricielle suivante :

$$(C + Id)M^{\text{ind}} + CM^{\text{per}} = f(H_0)$$

ou Id est la matrice identité et C est une matrice qui depend du maillage de la géométrie, de l'épaisseur de la tôle et de la perméabilité relative $\mu_r$.

4. Procédé selon les revendications 2 et 3, **caractérisé en ce que** le calcul des aimantations permanentes et induites de chacune des surfaces élémentaires est effectué par résolution du système matriciel suivant, sa solution étant $\tilde{\mathbf{M}}$ :

$$\begin{bmatrix} F & F \\ C + Id & C \end{bmatrix} \begin{bmatrix} M^{\text{ind}} \\ M^{\text{per}} \end{bmatrix} = \begin{bmatrix} B - Bo \\ D \end{bmatrix}$$

5. Procédé selon la revendication 4, **caractérisé en ce que** le calcul de la signature magnétique S de la tôle en un point I est effectué par l'une des formules suivantes :

$$S = \mathbf{B}_0 + \frac{e\mu_0}{4\pi} \sum_{N_l} \int_{L_i} \tilde{\mathbf{M}}_i . \mathbf{n}_i \frac{\vec{r}}{r^3} dL_i$$

$$S = \mathbf{B}_0 - \frac{e\mu_0}{4\pi} \sum_{N_l} \mathbf{grad} \iint_{S_i} \tilde{\mathbf{M}}_i . \frac{\vec{r}}{r^3} dS_i$$

$\tilde{\boldsymbol{M}}$ représente les aimantations estimées

$\mathbf{N_l}$ est le nombre d'éléments de surface (facette triangulaire ou quadrangulaire).

$\mathbf{L_i}$ les arêtes des éléments,

**S$_i$** les surface des éléments

**r** est la distance entre le barycentre de l'élément de surface courant et le point de calcul du champ.

**n$_i$** est la normale à l'arête i de l'élément de surface courant, tangentielle à l'élément.

**e** est l'épaisseur de la coque.

6. Procédé selon l'une quelconque des revendications 1 à 4, **caractérisé en ce qu'**il comporte une étape consistant à compenser l'aimantation de la tôle ou sa signature magnétique par utilisation d'un système de boucles d'immunisation disposées à proximité de la tôle et dans lesquelles peuvent être généré un courant d'intensité I réglable.

7. Procédé selon la revendication 5, **caractérisé en ce qu'**il comporte une première étape consistant à établir un système linéaire G reliant les courants 1 aux aimantations M' qu'ils génèrent sur la tôle et fonction des géométries de la tôle et des boucles, et une seconde étape consistant à minimiser la fonction $\tilde{M}$ -M'

8. Procédé selon la revendication 6, **caractérisé en ce que** l'étape de minimisation de la fonction $\tilde{M}$ -M' est effectuée par la méthode des moindres carrés.

9. Application d'un procédé selon l'une quelconque des revendications précédentes à la détermination de l'aimantation et de la signature magnétique de la coque d'un navire.

10. Application d'un procédé selon l'une quelconque des revendications précédentes à la détermination de l'aimantation et de la signature magnétique de l'ensemble d'un navire.

11. Application d'un procédé selon l'une quelconque des revendications précédentes à la détermination de l'aimantation et de la signature magnétique d'une structure ferromagnétique.

**Claims**

1. Method for determining the magnetization of the field radiated by a ferromagnetic sheet using magnetic field sensors distributed along this sheet at known positions relative to said sheet, **characterized by** consisting of:

    - meshing this sheet by dividing it up into elementary surfaces,
    - creating a first magnetic field model that is associated with the measurements and is a function of the surface mesh of the sheet, its thickness, the measurements, the coordinates of the measurement points, and the inductive field $B_0=\mu_0 H_0$,
    - creating a second model of the physical behavior of the material of which the sheet is made from the mesh, its thickness, the inductive field, and the reversible permeability of the material,
    - calculating the permanent $M^{per}$ and induced $M^{ind}$ magnetization and induced magnetizations of each of the elementary surfaces from said first and second models and the measurements made by said magnetic field sensors,
    - calculating the magnetic signature of the sheet at all points from said permanent and induced magnetizations of each of the elementary surfaces, from the surface mesh produced in the sheet, its thickness, the measurements, the coordinates of the calculation points, and the inductive field $B_0=\mu_0 H_0$.

2. Method according to Claim 1, **characterized in that** the first modeling procedure consists of modeling the magnetic field by a formula connecting the magnetic field measured by the sensors, the magnetization, the inductive field, and the geometry, such as one of the following formulas:

$$\mathbf{B} = \mathbf{B_0} + \frac{e\mu_0}{4\pi} \sum_{N_1} \int_{L_i} \mathbf{M}_i . \mathbf{n}_i \frac{\vec{r}}{r^3} dL_i$$

$$\mathbf{B} = \mathbf{B}_0 - \frac{e\mu_0}{4\pi} \sum_{N_1} \mathbf{grad} \iint_{S_i} \mathbf{M}_i \cdot \frac{\vec{r}}{r^3} dS_i$$

where

$\mathbf{M_i}$ is the total magnetization, namely the sum of the permanent magnetization $M_i^{per}$ and the induced magnetization

$M_i^{ind}$ of element i,

$\mathbf{N_1}$ is the number of elementary surfaces,

$\mathbf{L_i}$ the edges of the elementary surfaces,

$\mathbf{S_i}$ the elementary surfaces,

$\mathbf{r}$ is the distance between the current point of the edge i and the measurement point,

$\mathbf{n_i}$ is the perpendicular to the edge i of the current surface element, tangential to the element,

$\mathbf{e}$ is the thickness of the hull,

namely a matrix system taking the following matrix form:

$$B - Bo = FM = FM^{ind} + FM^{per}$$

3. Method according to any of claims 1 and 2, **characterized in that** the second modeling procedure consists of modeling the magnetic behavior of the sheet by a formula connecting magnetization, the inductive field, the reversible relative permeability of the material, and the geometry, such as one of the following formulas:

$$\frac{\mathbf{M}_i^{ind}}{(\mu_r - 1)} = \mathbf{H}_0 - \frac{e}{4\pi} \sum_{N_1} \int_{L_j} \mathbf{M}_j^{ind} \cdot \mathbf{n}_j \frac{\vec{r}_{ij}}{r_{ij}^3} dL_j - \frac{e}{4\pi} \sum_{N_1} \int_{L_j} \mathbf{M}_j^{per} \cdot \mathbf{n}_j \frac{\vec{r}_{ij}}{r_{ij}^3} dL_j$$

$$\frac{\mathbf{M}_i^{ind}}{(\mu_r - 1)} = \mathbf{H}_0 + \frac{e}{4\pi} \sum_{N_1} \mathbf{grad} \iint_{S_j} \mathbf{M}_j^{ind} \frac{\vec{r}_{ij}}{r_{ij}^3} dS_j + \frac{e}{4\pi} \sum_{N_1} \mathbf{grad} \iint_{S_j} \mathbf{M}_j^{per} \frac{\vec{r}_{ij}}{r_{ij}^3} dS_j$$

where,

$\mathbf{M}_j^{ind}$ is the induced magnetization of the elementary surface j,

$\mathbf{M}_j^{per}$ is the permanent magnetization of the elementary surface j,

$\mathbf{N_1}$ is the number of elementary surfaces,

$\mathbf{L_j}$ the edges of the elementary surfaces,

$\mathbf{S_j}$ the elementary surfaces,

$\mathbf{r_{ij}}$ is the distance between the centers of mass of surface elements i and j,

$\mathbf{n_j}$ is the perpendicular to edge i of the current surface element, tangential to the element,

$\mathbf{e}$ is the hull thickness,

namely, as a whole, a matrix system assuming the following matrix form:

$$(C + Id)M^{ind} + CM^{per} = f(H_0)$$

where Id is the identity matrix and C is a matrix which is dependent on the geometry of the mesh, the thickness of the plate and the relative permeability $\mu$.r.

4. Method according to Claims 2 and 3, **characterized in that** the permanent and induced magnetizations of each of the elementary surfaces are calculated by resolving the following matrix system, its solution being $\tilde{\mathbf{M}}$:

$$\begin{bmatrix} F & F \\ C + Id & C \end{bmatrix} \begin{bmatrix} M^{ind} \\ M^{per} \end{bmatrix} = \begin{bmatrix} B - Bo \\ D \end{bmatrix}$$

5. Method according to Claim 4, **characterized in that** the magnetic signature S of the sheet at a point I is calculated by one of the following formulas:

$$S = \mathbf{B}_0 + \frac{e\mu_0}{4\pi} \sum_{N_1} \int_{L_i} \tilde{\mathbf{M}}_i . \mathbf{n}_i \frac{\vec{r}}{r^3} dL_i$$

$$S = \mathbf{B}_0 - \frac{e\mu_0}{4\pi} \sum_{N_1} \mathbf{grad} \iint_{S_i} \tilde{\mathbf{M}}_i . \frac{\vec{r}}{r^3} dS_i$$

$\tilde{\boldsymbol{M}}$ represents the estimated magnetic signature
$\mathbf{N_1}$ is the number of surface elements (triangular or quadrangular facet)
$\mathbf{L_i}$ the edges of the elements,
$\mathbf{S_i}$ the surfaces of the elements,
$\mathbf{r}$ is the distance between the center of mass of the current surface element and the field calculation point,
$\mathbf{n_i}$ is the perpendicular to the edge i of the current surface element, tangential to the element,
$\mathbf{e}$ is the hull thickness.

6. Method according to any one of claims 1 to 4, **characterized by** having a step consisting of offsetting the magnetization of the sheet or its magnetic signature by using a system of immunization loops located in the vicinity of the sheet and in which a current with adjustable intensity I can be generated.

7. Method according to Claim 5, **characterized by** having a first step consisting of establishing a linear system G connecting the currents I to the magnetizations M' that they generate on the sheet and which is a function of the geometries of the sheet and the loops, and a second step consisting of minimizing the function $\tilde{M}$ -M'

8. Method according to Claim 6, **characterized in that** the function M-M' minimization step is carried out by the least squares method.

9. Application of a method according to any one of foregoing claims to determination of the magnetization and the magnetic signature of the hull of a ship.

10. Application of a method according to any one of foregoing claims to determination of the magnetization and the magnetic signature of an entire ship.

**11.** Application of a method according to any one of foregoing claims to determination of the magnetization and the magnetic signature of a ferromagnetic structure.

**Patentansprüche**

**1.** Verfahren zur Bestimmung der Magnetisierung und des von einem ferromagnetischen Blech abgestrahlten Feldes, wobei Magnetfeldsensoren verwendet werden, die entlang des Blechs an bekannten Positionen im Verhältnis zu dem Blech verteilt sind, **dadurch gekennzeichnet, daß** es folgende Schritte umfaßt:

- Durchführen einer Maschenbildung des Blechs durch Aufteilen in elementare Oberflächen,
- Durchführen einer ersten Modellierung des Magnetfeldes zugeordnet zu den Messungen und abhängig von der durchgeführten Oberflächenmaschenbildung des Blechs, seiner Dicke, den Meßwerten, den Koordinaten der Meßpunkte und dem Induktionsfeld $B_0 = \mu_0 H_0$,
- Durchführen einer zweiten Modellierung des physikalischen Verhaltens des Materials, aus dem das Blech besteht, ausgehend von der Maschenbildung, seiner Dicke, dem Induktionsfeld, der reversiblen Permeabilität des Materials,
- Berechnen der permanenten Magnetisierung $M^{per}$ und der induzierten Magnetisierung $M^{ind}$ jeder der elementaren Oberflächen ausgehend von der ersten und der zweiten Modellierung und den von den Magnetfeldsensoren durchgeführten Messungen,
- Berechnen der magnetischen Signatur des Blechs in allen Punkten ausgehend von den permanenten und induzierten Magnetisierungen jeder der elementaren Oberflächen, von der vom Blech durchgeführten Oberflächenmaschenbildung, seiner Dicke, den Meßwerten, den Koordinaten der Berechnungspunkte und dem Induktionsfeld $B_0 = \mu_0 H_0$.

**2.** Verfahren gemäß Anspruch 1, **dadurch gekennzeichnet, daß** die erste Modellierung darin besteht, das Magnetfeld durch eine Formel zu modellieren, die das von den Sensoren gemessene Magnetfeld, die Magnetisierung, das Induktionsfeld und die Geometrie miteinander verbindet, wie eine der folgenden Formeln:

$$B = B_0 + \frac{e\mu_0}{4\pi} \sum_{N_l} \int_{L_i} M_i . n_i \frac{\vec{r}}{r^3} dL_i$$

$$B = B_0 - \frac{e\mu_0}{4\pi} \sum_{N_l} grad \int\int_{S_i} M_i . \frac{\vec{r}}{r^3} dS_i$$

in denen

$M_i$ die Gesamtmagnetisierung darstellt, d.h. die Summe der permanenten Magnetisierung $M_i^{per}$ und der induzierten Magnetisierung $M_i^{ind}$ des Elements i,

$N_1$ die Anzahl der elementaren Oberflächen ist,

$L_i$ die Kanten der elementaren Oberflächen,

$S_i$ die elementaren Oberflächen,

r der Abstand ist zwischen dem laufenden Punkt der Kante i und dem Meßpunkt,

$n_i$ die Normale an der Kante i des laufenden Oberflächenelements ist, tangential zum Element,

e die Dicke des Rumpfs ist,

d.h. ein Matrizensystem, das die folgende Matrizenform annimmt:

$$B - Bo = FM = FM^{ind} + FM^{per}$$

3. Verfahren gemäß Anspruch 1 oder 2, **dadurch gekennzeichnet, daß** die zweite Modellierung darin besteht, das magnetische Verhalten des Blechs durch eine Formel zu modellieren, die die Magnetisierung, das Induktionsfeld, die relative, umkehrbare Permeabilität des Materials und die Geometrie miteinander verbindet, wie eine der folgenden Formeln:

$$\frac{M_i^{ind}}{(\mu_r - 1)} = H_0 - \frac{e}{4\pi} \sum_{N_l} \int_{L_j} M_j^{ind} . n_j \frac{\vec{r}_{ij}}{r_{ij}^3} dL_j - \frac{e}{4\pi} \sum_{N_l} \int_{L_j} M_j^{per} . n_j \frac{\vec{r}_{ij}}{r_{ij}^3} dL_j$$

$$\frac{M_i^{ind}}{(\mu_r - 1)} = H_0 + \frac{e}{4\pi} \sum_{N_l} grad \iint_{S_j} M_j^{ind} \frac{\vec{r}_{ij}}{r_{ij}^3} dS_j + \frac{e}{4\pi} \sum_{N_l} grad \iint_{S_j} M_j^{per} \frac{\vec{r}_{ij}}{r_{ij}^3} dS_j$$

wobei

$M_j^{ind}$ die induzierte Magnetisierung der elementaren Oberfläche j ist,

$M_j^{per}$ die permanente Magnetisierung der elementaren Oberfläche j ist,

$N_1$ die Anzahl der elementaren Oberflächen ist,

$L_j$ die Kanten der elementaren Oberflächen,

$S_j$ die elementaren Oberflächen,

$r_{ij}$ der Abstand ist zwischen den Schwerpunkten der Oberflächenelemente i und j,

$n_j$ die Normale der Kante i des laufenden Oberflächenelements ist, tangential zu dem Element,

e die Dicke des Rumpfes ist,

d.h. allgemein ein Matrizensystem, das die folgende Matrizenform annimmt:

$$(C + Id)M^{ind} + CM^{per} = f(H_0)$$

wobei $I_d$ die Identitätsmatrix ist und C eine Matrix ist, die von der Maschenbildung, der Geometrie, der Dicke des Blechs und der relativen Permeabilität $\mu r$ abhängt.

4. Verfahren gemäß der Ansprüche 2 und 3, **dadurch gekennzeichnet, daß** die Berechnung der permanenten Magnetisierung und der induzierten Magnetisierung jedes der elementaren Oberflächen durchgeführt wird durch die Lösung des folgenden Matrizensystems, wobei seine Lösung $\tilde{M}$ ist:

$$\begin{bmatrix} F & F \\ C + Id & C \end{bmatrix} \begin{bmatrix} M^{ind} \\ M^{per} \end{bmatrix} = \begin{bmatrix} B - Bo \\ D \end{bmatrix}$$

5. Verfahren gemäß Anspruch 4, **dadurch gekennzeichnet, daß** die Berechnung der magnetischen Signatur S des Blechs an einem Punkt i mit einer der folgenden Formeln erfolgt:

$$S = B_0 + \frac{e\mu_0}{4\pi} \sum_{N_I} \int_{L_i} \widetilde{M}_i . n_i \frac{\vec{r}}{r^3} dL_i$$

$$S = B_0 - \frac{e\mu_0}{4\pi} \sum_{N_I} grad \iint_{S_i} \widetilde{M}_i . \frac{\vec{r}}{r^3} dS_i$$

$\widetilde{M}$ stellt die geschätzten Magnetisierungen dar,
$N_1$ ist die Zahl der Oberflächenelemente (dreieckige oder viereckige Facette),
$L_i$ die Kanten der Elemente,
$S_i$ die Oberflächen der Elemente,
r ist der Abstand zwischen dem Schwerpunkt des laufenden Oberflächenelements und dem Feldberechnungspunkt,
$n_i$ ist die Normale zur Kante i des laufenden Oberflächenelements, tangential zum Element,
e ist die Dicke des Rumpfs.

6.  Verfahren gemäß einem der Ansprüche 1 bis 4, **dadurch gekennzeichnet, daß** es einen Schritt umfaßt, der darin besteht, die Magnetisierung des Blechs oder seine magnetische Signatur zu kompensieren durch die Verwendung eines Systems von Immunisierungsschleifen, die in der Nähe des Blechs angeordnet sind und in denen ein Strom regelbarer Stärke erzeugt werden kann.

7.  Verfahren gemäß Anspruch 5, **dadurch gekennzeichnet, daß** es einen ersten Schritt umfaßt, der darin besteht, ein lineares System G zu erstellen, das die Ströme I mit den Magnetisierungen M', die sie auf dem Blech erzeugen, verbindet und das abhängt von den Geometrien des Blechs und der Schleifen und einen zweiten Schritt umfaßt, der darin besteht die Funktion $\widetilde{M}$ -M' zu minimieren.

8.  Verfahren gemäß Anspruch 6, **dadurch gekennzeichnet, daß** der Schritt der Minimierung der Funktion $\widetilde{M}$ -M' durchgeführt wird mit der Methode der kleinsten Fehlerquadrate.

9.  Anwendung eines Verfahrens gemäß einem der vorangegangenen Ansprüche auf die Bestimmung der Magnetisierung und der magnetischen Signatur eines Schiffsrumpfs.

10. Anwendung eines Verfahrens gemäß einem der vorangegangenen Ansprüche auf die Bestimmung der Magnetisierung und der magnetischen Signatur eines gesamten Schiffs.

11. Anwendung eines Verfahrens gemäß einem der vorangegangenen Ansprüche auf die Bestimmung der Magnetisierung und der magnetischen Signatur einer ferromagnetischen Struktur.

Fig. 1

Modèle CAO de la coque ou de la tôle

Paramètre d'épaisseur e

Champ inducteur H

perméabilité $\mu_r$

Coordonnées des points de calcul de la signature de la coque ou de la tôle

Sortie aimantations compensées

Géométrie des boucles

Coordonnées des points de mesures (capteurs)

Construction du Maillage surfacique

Modélisation du comportement physique du matériau

Modélisation du champ magnétique associé aux mesures

Construction d'un modèle global

Inversion du modèle

Estimation des aimantations

Dispositif de compensation des aimantations

Acquisition des mesures capteurs

Calcul de la signature S

Figure 2

Figure 3

Figure 4

Figure 5

Figure 6

Figure 7

Figure 8

Figure 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- FR 2673236
- FR 2659787
- US 5189590 A
- FR 2679514